(19) Europäisches Patentamt
European Patent Office
Office européen des brevets

(11) EP 4 408 020 A1

(12) **EUROPEAN PATENT APPLICATION**
published in accordance with Art. 153(4) EPC

(43) Date of publication:
31.07.2024 Bulletin 2024/31

(21) Application number: 22942109.4

(22) Date of filing: 20.05.2022

(51) International Patent Classification (IPC):
H04R 1/22 (2006.01)    H04R 17/10 (2006.01)

(52) Cooperative Patent Classification (CPC):
H04R 1/22; H04R 17/10

(86) International application number:
PCT/CN2022/094006

(87) International publication number:
WO 2023/221069 (23.11.2023 Gazette 2023/47)

(84) Designated Contracting States:
AL AT BE BG CH CY CZ DE DK EE ES FI FR GB
GR HR HU IE IS IT LI LT LU LV MC MK MT NL NO
PL PT RO RS SE SI SK SM TR
Designated Extension States:
BA ME
Designated Validation States:
KH MA MD TN

(71) Applicant: Shenzhen Shokz Co., Ltd.
Shenzhen, Guangdong 518108 (CN)

(72) Inventors:
• YUAN, Yongshuai
Shenzhen, Guangdong 518000 (CN)
• QI, Xin
Shenzhen, Guangdong 518000 (CN)
• LIAO, Fengyun
Shenzhen, Guangdong 518000 (CN)

(74) Representative: Fuchs Patentanwälte
Partnerschaft mbB
Tower 185
Friedrich-Ebert-Anlage 35-37
60327 Frankfurt am Main (DE)

(54) **VIBRATION SENSOR AND MICROPHONE**

(57) In a vibration sensor and a microphone provided in this specification, both ends of a vibration beam are fixed on a base, and a middle portion is suspended in a cavity and generates deformation in response to external vibrational excitation. According to the vibration sensor and the microphone, portions, suspended in the cavity, of a plurality of vibration beams have different dimensions by changing a structure and a dimension of the cavity and a dimension and a position of each vibration beam, so that different vibration beams have different natural frequencies, and resonance peaks of different frequencies are generated under vibrational excitation, forming a wider frequency response range. In addition, a vibration signal selected by the vibration sensor and the microphone is a vibration signal within a preset range near the resonance peak, and sensitivity is higher. Moreover, in the vibration sensor and the microphone, a dimension of the cavity of the base is designed to realize multi-resonance peaks and a wide frequency band. The structure is simple, processing difficulty is low, processing costs are low, and a more accurate collection result of the vibration signal may be obtained.

FIG. 1

EP 4 408 020 A1

# Description

## TECHNICAL FIELD

This specification relates to the field of sensors, and in particular, to a vibration sensor and a microphone.

## BACKGROUND

In the existing technology, vibration sensors such as an accelerometer, a speaker, a gyroscope, an energy harvester, a bone-conduction microphone, and an air-conduction microphone widely use a diaphragm and mass block structure or a cantilever beam and mass block structure. For example, a microphone uses a diaphragm and mass block structure or a cantilever beam and mass block structure in the vibration sensor to receive external vibrational excitation, and convert the vibrational excitation into an electrical signal. The electrical signal is output after being processed by a back-end circuit for collection of a sound signal. An air-conduction microphone may collect air vibration generated when a user makes a sound, and convert the air vibration into an electrical signal. A bone-conduction microphone may collect mechanical vibration of bones and skin generated when a user speaks, and convert the mechanical vibration into an electrical signal. Higher sensitivity and wider frequency response range to vibrational excitation have always been goals pursued for a vibration sensor. However, due to characteristics of a vibration system, sensitivity attenuates sharply after a resonance peak occurs, and generally the higher a resonance frequency, the lower the sensitivity. Consequently, it is difficult for a single-resonance peak vibration sensor to take into account characteristics of both high sensitivity and wide frequency band. In addition, the single-resonance peak often cannot meet a demand. Multi-resonance peak vibration sensors in the existing technology have a complex structure and high processing difficulty, resulting in high costs and low precision.

Therefore, there is a need to provide a vibration sensor and a microphone that have a wider frequency response range, higher sensitivity, and a simple structure.

## BRIEF SUMMARY

This specification provides a vibration sensor and a microphone that have a wider frequency response range, higher sensitivity, and a simple structure.

According to a first aspect, this specification provides a vibration sensor, including a base and a plurality of vibration beams. The base may include a cavity; and the plurality of vibration beams may be sequentially arranged on the base. Each vibration beam may include a fixed terminal and a movable terminal. The fixed terminal may be located at both ends of the vibration beam and connected to the base; and the movable terminal may be connected to the fixed terminal, located between the fixed terminal, and suspended in the cavity. A portion, suspended in the cavity, of each vibration beam may have different dimensions and different natural frequencies, and each vibration beam may generate, in response to external vibrational excitation, a vibration signal in a sub-target frequency window including a natural frequency corresponding to the vibration beam.

In some embodiments, a plurality of sub-target frequency windows corresponding to the plurality of vibration beams may cover different frequency ranges, and the plurality of sub-target frequency windows may constitute a target frequency window.

In some embodiments, a plurality of natural frequencies corresponding to the plurality of vibration beams may be evenly distributed within the target frequency window.

In some embodiments, a dimension of the cavity in a first direction may change along a second direction, the plurality of vibration beams may be arranged on the base along the second direction, and the fixed terminal may be connected to the base along the first direction.

In some embodiments, the dimension of the cavity in the first direction, a connection position of each vibration beam on the cavity, and a dimension of each vibration beam may satisfy a preset rule, so that the natural frequency of each vibration beam may satisfy a preset value.

In some embodiments, the movable terminal generates deformation in response to the vibrational excitation, and the movable terminal may include a piezoelectric sensing component and a connecting beam. The piezoelectric sensing component may be configured to convert the deformation into the vibration signal, and the vibration signal may include an electrical signal; and the connecting beam may be connected to the piezoelectric sensing component.

In some embodiments, a distance between the piezoelectric sensing component and one end of the fixed terminal may range from one quarter to three quarters of a length of the movable terminal.

In some embodiments, the movable terminal may include two piezoelectric sensing components, which may be respectively close to both ends of the fixed terminal, and a distance between each piezoelectric sensing component and an end, close to the piezoelectric sensing component, of the fixed terminal may be less than 1/4 of a length of the movable terminal.

In some embodiments, the piezoelectric sensing component may include at least one of a piezoelectric single crystal structure and a piezoelectric twin structure.

In some embodiments, each vibration beam may further include a counterweight, connected to the movable terminal. The movable terminal may generate deformation in response to the vibrational excitation, and the counterweight may be displaced based on the deformation.

In some embodiments, a dimension of the cavity in a first direction, a connection position of each vibration beam on the cavity, a dimension of each vibration beam, and a dimension of the counterweight may satisfy a preset rule, so that the natural frequency of each vibration beam may satisfy a preset value.

In some embodiments, the dimension of the counterweight may be matched with the natural frequency of the vibration beam corresponding to the counterweight, so that a deviation of the vibration signal in the natural frequencies corresponding to the plurality of vibration beams may be within a preset deviation range.

According to a second aspect, this specification may further provide a microphone, including a housing, the vibration sensor described in the first aspect of this specification, and a signal synthesizing circuit. The vibration sensor may be mounted in the housing, and the base may be fixedly connected to the housing. The signal synthesizing circuit may be connected to the plurality of vibration beams and configured to collect the vibration signal during operation and perform signal synthesis processing on the vibration signal, to generate a vibration signal within a target frequency window. A plurality of sub-target frequency windows corresponding to the plurality of vibration beams may cover different frequency ranges, and the plurality of sub-target frequency windows may constitute the target frequency window.

As can be learned from the foregoing technical solutions, for a vibration sensor and a microphone provided in this specification, both ends of a vibration beam may be fixed on a base, and a middle portion may be suspended in a cavity and generate deformation in response to external vibrational excitation. According to the vibration sensor and the microphone, portions, suspended in the cavity, of a plurality of vibration beams may have different dimensions by changing a structure and a dimension of the cavity and a dimension and a connection position of each vibration beam, so that different vibration beams may have different natural frequencies, and resonance peaks of different frequencies may be generated under vibrational excitation. The plurality of vibration beams may generate vibration signals with a plurality of different frequency ranges, and the vibration signals with the plurality of different frequency ranges may together constitute a vibration signal with a wide frequency band, making the vibration sensor have a wider frequency response range. In addition, a vibration signal selected by the vibration sensor and the microphone may be a vibration signal within a preset range near the resonance peak, so that the sensitivity may be higher. Moreover, for the vibration sensor and the microphone, a dimension of the cavity of the base may be designed to realize multi-resonance peaks and a wide frequency band. The structure can be simple, processing difficulty may be low, processing costs may be low, and a more accurate collection result of the vibration signal may be obtained.

Other functions of the vibration sensor and the microphone provided in this specification are listed in the following descriptions. Based on description, content introduced by the following figures and examples are obvious to those of ordinary skill in the art. Creative aspects of the vibration sensor and the microphone provided in this specification may be fully explained by practicing or using a method, an apparatus, and a combination described in the following detailed examples.

## BRIEF DESCRIPTION OF THE DRAWINGS

To clearly describe the technical solutions in the embodiments of this specification, the following briefly describes the accompanying drawings required for describing the embodiments. Evidently, the accompanying drawings in the following description show merely some embodiments of this specification, and a person of ordinary skill in the art may still derive other drawings from these accompanying drawings without creative efforts.

FIG. 1 is a side view of a vibration sensor according to some embodiments of this specification;
FIG. 2 is a front view of a vibration sensor according to some embodiments of this specification;
FIG. 3 is a top view of a vibration sensor according to some embodiments of this specification;
FIG. 4 is a right view of a vibration sensor according to some embodiments of this specification;
FIG. 5 is a sectional view A-A of FIG. 2;
FIG. 6 is a schematic diagram of a piezoelectric single crystal structure according to some embodiments of this specification;
FIG. 7 is a schematic diagram of a piezoelectric twin structure according to some embodiments of this specification;
FIG. 8 is a normalized displacement resonance graph according to some embodiments of this specification; and
FIG. 9 is a schematic diagram of a vibration signal according to some embodiments of this specification.

## DETAILED DESCRIPTION

The following description provides specific application scenarios and requirements of this specification, with the purpose of enabling those skilled in the art to make and use the content in this specification. For those skilled in the art, various partial modifications to the disclosed embodiments are obvious, and without departing from the spirit and scope of this specification, the general principles defined herein can be applied to other embodiments and application. Therefore, this specification is not limited to the embodiments, but is consistent with the broadest scope of the claims.

The terms used herein are merely intended to describe specific exemplarily embodiments, rather than limiting this specification. For example, unless explicitly stated otherwise, the singular forms "a", "an" and "the" used herein may also include plural forms. When used in this specification, the terms "comprise", "include", and/or "contain" indicate the presence of associated integers, steps, operations, elements, and/or components, but do not exclude the presence of one or more other features, integers, steps, operations, elements, components, and/or sets or addition of other features, integers, steps, operations, elements, components, and/or sets to the system/method.

In consideration of the following description, in this specification, these and other features, the operation and function of related elements of the structure, as well as the economics of the combination and manufacturing of components can be significantly improved. With reference to the accompanying drawings, all of these form part of this specification. However, it should be clearly understood that the accompanying drawings are merely intended for illustration and description purposes, rather than to limit the scope of this specification. It should be further understood that the accompanying drawings are not drawn to scale.

It should be understood that, to facilitate description of this specification, position relationships indicated by terms such as "center", "upper surface", "lower surface", "upper", "lower", "top", "bottom", "inner", "outer", "axial", "radial", "periphery", and "external" are position relationships based on the accompanying drawings, and are not intended to indicate that the apparatus, module, or unit referred to must have a particular position relationship, so that they cannot be interpreted as limiting this specification.

It should be understood that "system", "apparatus", "unit", and/or "module" used in this specification are used to differentiate between different modules, elements, components, parts, or assemblies of different levels. However, if another word can achieve the same purpose as one word, this word can be replaced with another expression.

The flowchart used in this specification illustrates the operations implemented by the system according to some embodiments in this specification. It should be clearly understood that the operations of the flowchart may be implemented out of sequence. Instead, the operations may be implemented in reverse sequence or simultaneously. In addition, one or more other operations may be added to the flowchart. One or more operations may be removed from the flowchart.

For ease of understanding, the terms used in this specification are first explained as follows:
Sensitivity refers to a ratio of an output signal to an input signal. For a vibration sensor, the input signal may be external vibrational excitation, and the output signal may be an electrical signal generated in response to the vibrational excitation. Sensitivity of the vibration sensor refers to a ratio of an output electrical signal to input vibrational excitation, where the output electrical signal may be converted into the amplitude of a vibration signal. Therefore, the sensitivity of the vibration sensor may also be understood as a ratio of the amplitude of the output vibration signal to the amplitude of the input vibrational excitation. When a dimension of the output signal is the same as that of the input signal, the sensitivity may be understood as an amplification factor of the input signal. Higher sensitivity indicates better collection performance of the vibration sensor for tiny vibrational excitation.

Resonance, also referred to as "syntony", refers to a phenomenon that, when a vibration system is under an action of periodic external vibrational excitation, an amplitude of the system increases sharply when a frequency of external vibrational excitation is the same as or very close to a natural vibration frequency of the system. A frequency at which resonance occurs is called "resonance frequency".

Resonance peak refers to a peak value of the resonance frequency.

A vibration sensor and a microphone provided in this specification may be configured to collect external vibrational excitation, and convert the vibrational excitation into an electrical signal. The vibration sensor and the microphone may be configured to collect not only vibrational excitation caused by an air vibration, but also vibrational excitation caused by a mechanical vibration, such as vibrations of bones and skin generated when a person speaks. The vibration sensor and the microphone may be used as not only air-conduction microphones, but also bone-conduction microphones.

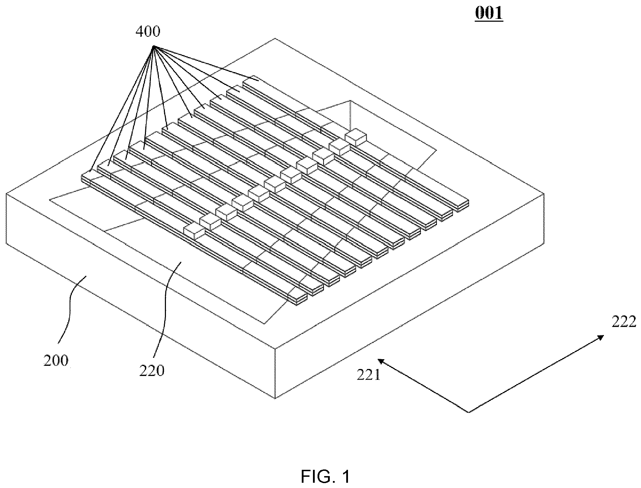

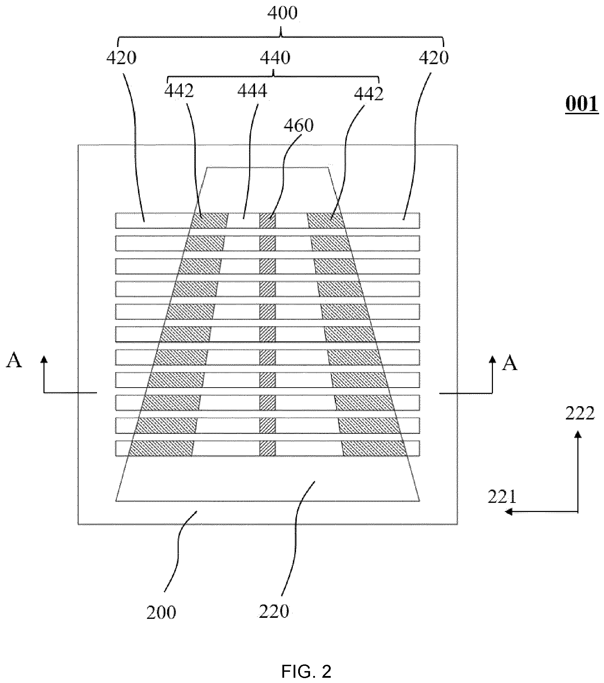

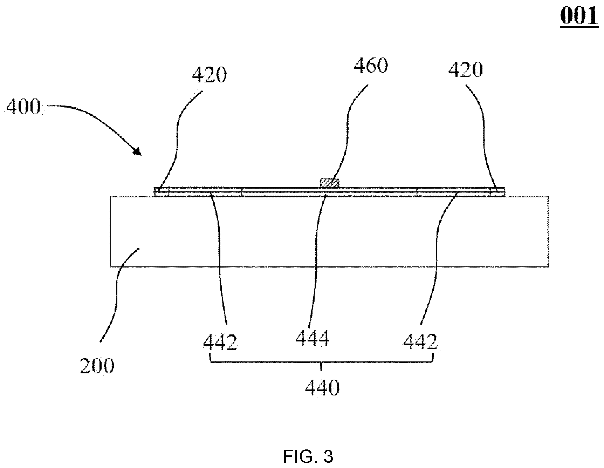

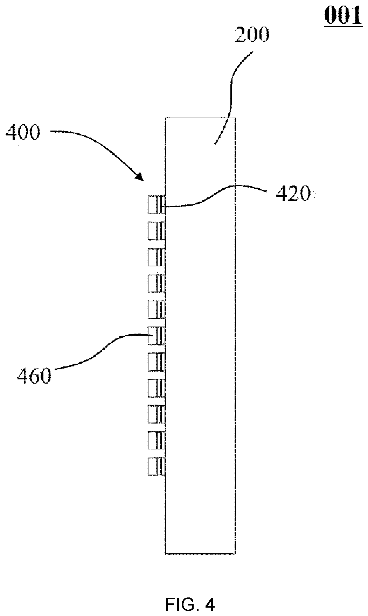

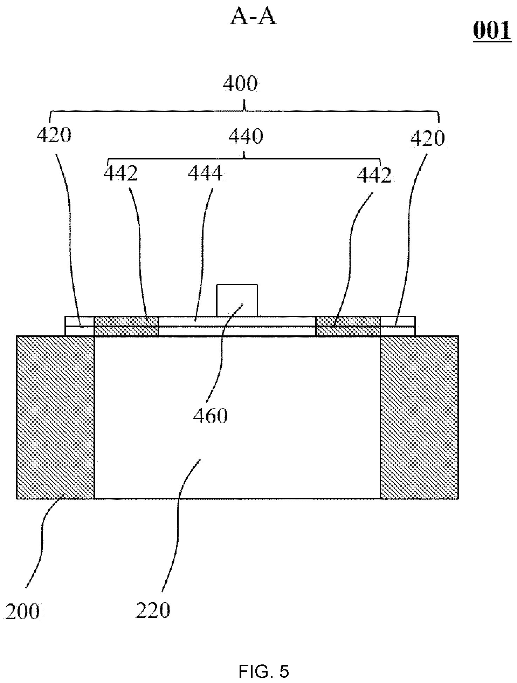

FIG. 1 is a side view of a vibration sensor 001 according to some embodiments of this specification; FIG. 2 is a front view of a vibration sensor 001 according to some embodiments of this specification; FIG. 3 is a top view of a vibration sensor 001 according to some embodiments of this specification; FIG. 4 is a right view of a vibration sensor 001 according to some embodiments of this specification; and FIG. 5 shows the sectional view A-A in FIG. 2. As shown in FIG. 1 to FIG. 5, the vibration sensor 001 may include a base 200 and a plurality of vibration beams 400.

The base 200 may be a mounting base for the vibration sensor 001. Other components, such as the vibration beams 400, of the vibration sensor 001 may be connected to the base 200 directly or indirectly. The connection may be implemented in any manner, for example, a fixed connection manner such as welding, riveting, clamping, or bolting, or a deposition manner such as physical deposition (for example, physical vapor deposition) or chemical deposition (for example, chemical vapor deposition). The base 200 may be a structural body of any shape, for example, a regular-shaped structural body such as a cube, a cuboid, a cylinder, a prismoid, and a truncated cone, or any irregular-shaped structural body. A material of the base 200 may be Si, $SiO_2$, SiNx, or the like. In some embodiments, the base 200 may include a cavity 220. In some embodiments, the cavity 220 may penetrate the base 200. In some embodiments, the cavity 220 may not penetrate the base 200. Referring to exemplary descriptions shown in FIG. 1 to FIG. 5, the cavity 220 may penetrate an upper surface and a lower surface of the base 200.

In some embodiments, the cavity 220 may be one piece. In some embodiments, the cavity 220 may include a plurality of spaced sub-cavities. For ease of description, the cavity 220 shown in FIG. 1 to FIG. 5 is one piece. A person skilled in the art should understand that the cavity 220 including a plurality of spaced sub-cavities also falls within the protection scope of this specification.

A dimension of the cavity 220 in a first direction 221 may vary along a second direction. That is, the dimension of the cavity 220 in the first direction 221 changes as its position in the second direction 222 changes. In other words, the cavity 220 has different dimensions in the first direction 221 at different positions of the cavity 220 in the second direction 222. The first direction 221 and the second direction 222 are not the same direction. That is, the first direction 221 and the second direction 222 form an angle. The angle may be an acute angle, a right angle, or an obtuse angle. In some embodiments, the first direction 221 is perpendicular to the second direction 222. A cross-sectional shape of the cavity 220 may be any shape that meets the foregoing conditions, such as a circle, an ellipse, a quadrilateral, a pentagon, a hexagon, a heptagon, an octagon, or even an irregular shape, such as a varied-curvature curve shape. The cavity 220 with different shapes may correspond to different first directions 221 and different second directions 222. In some embodiments, the cross-sectional shape of the cavity 220 may be a quadrilateral, such as a square, the first direction 221 may be a direction of one diagonal of the square, and the second direction 222 may be a direction of the other diagonal of the square. In some embodiments, the cross-sectional shape of the cavity 220 may be a rectangle, the first direction 221 may be a direction forming an acute angle with the length or width of the rectangle and the second direction 222 may be a direction perpendicular to the first direction. In some embodiments, the cross-sectional shape of the cavity 220 may be a parallelogram, the first direction 221 may be a direction forming an acute angle with one side of the parallelogram, and the second direction 222 may be a direction perpendicular to the first direction. In some embodiments, the cross-sectional shape of the cavity 220 may be a trapezoid, such as an isosceles trapezoid, the second direction 222 may be a height direction of the isosceles trapezoid, and the first direction 221 may be a direction perpendicular to the second direction 222. In some embodiments, the second direction 222 may alternatively be a direction forming an acute angle with a height direction of the isosceles trapezoid, and the first direction 221 may be a direction perpendicular to the second direction 222. In some embodiments, the cross-sectional shape of the cavity 220 may alternatively be a right-angled trapezoid, the second direction 222 may be a height direction of the right-angled trapezoid, and the first direction 221 may be a direction perpendicular to the second direction 222. In some embodiments, the cross-sectional shape of the cavity 220 may alternatively be another quadrilateral, such as a trapezoid other than isosceles trapezoid and right-angled trapezoid, for example, a rhombus, a trapezium, and so on. In some embodiments, the cross-sectional shape of the cavity 220 may be circular, the first direction 221 may be a direction of any diameter of the circular, and the second direction 222 may be a direction perpendicular to the first direction 221. In some embodiments, the cross-sectional shape of the cavity 220 may be an ellipse, the first direction 221 may be a long-axis direction or a short-axis direction of the ellipse, and the second direction 222 may be a direction perpendicular to the first direction.

The cross-sectional shape of the cavity 220 shown in FIG. 1 to FIG. 5 is an isosceles trapezoid, where the second direction 222 is a height direction of the isosceles trapezoid, and the first direction 221 and the second direction 222 are perpendicular to each other. The cavity 220 has different dimensions in the first direction 221 when the cavity 220 is at different positions in the second direction 222. A person skilled in the art should understand that the cavity 220 being another shape that meets the foregoing conditions also falls within the protection scope of this specification.

An edge of the cavity 220 may be straight, curved, jagged, or the like. In some embodiments, the edge of the cavity 220 may be formed by straight lines. The dimension of the cavity 220 may be designed based on an application scenario of the vibration sensor 001 and a requirement for vibrational excitation. For example, the cavity 220 may have different dimensions when the vibration sensor 001 is used as an accelerometer and as an air-conduction microphone. In some embodiments, the dimension of the cavity 220 may be related to a dimension of the vibration beam 400, which will be described in detail in the following description.

As shown in FIG. 1 to FIG. 5, the vibration sensor 001 may include a plurality of vibration beams 400. The vibration beams 400 may be connected to the base 200, generate deformation in response to external vibrational excitation, and convert the deformation into a vibration signal. In some embodiments, the vibration signal may be an electrical signal. The vibrational excitation may be air vibrational excitation directly acting on the vibration beams 400 or mechanical vibrational excitation acting on the base 200. The vibration beam 400 may be a plate-shaped structural body of any shape, for example, may be a rectangular beam, a trapezoidal beam, an L-shaped beam, a beam of another shape, or the like. The plurality of vibration beams 400 may be sequentially arranged on the base 200 along the second direction 222. In some embodiments, the vibration beam 400 may be a clamped beam, that is, both ends of the vibration beam 400 may be connected to the base 200, and a middle portion may be suspended in the cavity 220. Specifically, each vibration beam 400 may include a fixed terminal 420 and a movable terminal 440. In some embodiments, each vibration beam 400 may further include a counterweight 460.

The fixed terminal 420 may be located at both ends of the vibration beam 400 (that is, the fixed terminal may have two parts respectively located at two ends of the vibration beam). The fixed terminal 420 may be connected to the base 200 along the first direction 221. That is, both ends of the fixed terminal 420 may be distributed along the first direction 221. For ease of description, a distribution direction of both ends of the fixed terminal 420 is defined as a length direction, or an axial direction, of the vibration beam 400. The connection between the fixed terminal 420 and the base 200 may be implemented in any manner, for example, a fixed connection manner such as welding, riveting, clamping, or bolting, or a deposition manner such as physical deposition (for example, physical vapor deposition) or chemical deposition (for example, chemical vapor deposition). The fixed terminal 420 may be connected to the base 200 in an insulated manner. For example, the fixed terminal 420 may be connected to the base 200 through an insulation layer. A material of the fixed terminal 420 may be Si, $SiO_2$, SiNx, or the like.

In some embodiments, the fixed terminal 420 may be fixedly connected to an upper surface or a lower surface of the base 200 or an inner wall of the cavity 220. In the schematic diagrams shown in FIG. 1 to FIG. 5, an example in which the fixed terminal 420 is connected to the upper surface of the base 200 is used for description. A person skilled in the art should understand that the fixed terminal 420 being connected to another position of the base 200 also falls within the protection scope of this specification.

The movable terminal 440 may be connected to the fixed terminal 420, located between the fixed terminal 420 (that is, between the two arts of the fixed terminal), and suspended in the cavity 220. "Suspended in the cavity 220" may be suspended in, below, or above the cavity 220 of the base 200, without being in contact with the base 200. For ease of display, as shown in FIG. 1 to FIG. 5, the movable terminal 440 may be suspended above the cavity 220, which is merely an exemplary description.

The movable terminal 440 may generate deformation in response to the vibrational excitation, and convert the deformation into a vibration signal. In some embodiments, the movable terminal 440 may include a piezoelectric sensing component 442 and a connecting beam 444. The piezoelectric sensing component 442 may convert the deformation of the movable terminal 440 into the vibration signal, and the vibration signal may include an electrical signal. The connecting beam 444 may be connected to the piezoelectric sensing component 442.

The piezoelectric sensing component 442 may include a piezoelectric material. As described above, the vibration sensor 001 may receive external vibrational excitation, and convert the external vibrational excitation into an electrical signal. Specifically, the external vibrational excitation may deform the movable terminal 440, causing the piezoelectric material in the piezoelectric sensing component 442 to deform, thereby generating stress and outputting a voltage. Thus, the external vibrational excitation is converted into an electrical signal, and the electrical signal is then collected and regulated through a back-end circuit to obtain a required electrical signal. All piezoelectric materials conform to a piezoelectric effect constitutive equation. For the vibration sensor 001, a positive piezoelectric effect is applied, and a constitutive equation is as follows:

$$D_i = d_{ij}T_j + \varepsilon_{ij}^T E_j$$

where $d_{ij}$ is a piezoelectric strain coefficient, $T_j$ is stress, $\varepsilon_{ij}^T$ is a dielectric constant under a constant force, $E_j$ is an electric field strength, and $D_i$ is electrical displacement. For the vibration sensor 001, the electrical displacement $D_i$ is mainly caused by the stress formed by the external vibrational excitation. The constitutive equation may be further simplified to:

$$D_i = d_{ij}T_j$$

It may be learned from the foregoing formula that a magnitude of an output electrical displacement $D_i$ of the piezoelectric material depends on a piezoelectric strain coefficient $d_{ij}$ of the material itself and the stress $T_j$ formed by the piezoelectric material during operation. After the piezoelectric material is determined, it is an effective measure to increase output of the piezoelectric sensing component 442 by designing a structure to increase stress in a partial region of an effective piezoelectric material.

The piezoelectric sensing component 442 may be suspended in the cavity 220. In some embodiments, the piezoelectric sensing component 442 may be distributed over all regions of the movable terminal 440. In some embodiments, the piezoelectric sensing component 442 may be alternatively distributed over some regions of the movable terminal 440. The piezoelectric sensing component 442 may convert the deformation of the movable terminal 440 into a vibration signal, and output the vibration signal. When the movable terminal 440 moves relative to the base 200, deformation degrees at different positions of the movable terminal 440 may be different, and deformation stress on the piezoelectric sensing component 442 is also different. To improve sensitivity of the vibration sensor 001, in some embodiments, the piezoelectric sensing component 442 can be disposed at only a position, having a relatively high deformation degree and relatively large stress, of the movable terminal 440, thereby improving the sensitivity of the vibration sensor 001. For ease of description, the position, having a relatively high deformation degree and relatively large stress, of the movable terminal 440 is defined as a first region, and a position, having a relatively low deformation degree and relatively small stress, of the movable terminal 440 is defined as a second region. A voltage of the electrical signal in the first region is higher than a voltage of the electrical signal in the second region. In some embodiments, the piezoelectric sensing component 442 can be disposed only in the first region. It should be noted that, the first region and the second region are regions corresponding to the movable terminal 440, and do not include a region of the fixed terminal 420, namely, a region at a junction between the vibration beam 400 and the base 200.

A direction of the stress on the movable terminal 440 is related to an overall deformation direction of the movable terminal 440. When the movable terminal 440 vibrates downwards and vibrates upwards, its deformation directions are opposite. In this case, directions of stress on a same portion of the movable terminal 440 are also opposite. A region under compressive stress during upward vibration is subjected to tensile stress in downward vibration, and a region under tensile stress during upward vibration is subjected to compressive stress in downward vibration. For example, when the movable terminal 440 vibrates downward, and when the movable terminal 440 is deformed, axial stress on a lower surface of the movable terminal 440 is symmetrical with respect to the center of the movable terminal 440, and tensile stress on the center side decreases to zero, and then increases from zero to compressive stress. The zero points are located at one-quarter and three-quarters of an axial length of the movable terminal 440. When the movable terminal 440 vibrates upwards, and when the movable terminal 440 is deformed, axial stress on a lower surface of the movable terminal 440 is symmetrical with respect to the center of the movable terminal 440, and compressive stress on the center side decreases to zero, and then increases from zero to the tensile stress. The zero points are located at one-quarter and three-quarters of the axial length of the movable terminal 440.

Therefore, in order to improve the sensitivity of the piezoelectric sensing component 442, the piezoelectric sensing component 442 may be arranged in a region where stress is relatively large and has a same direction. For ease of presentation, the following description is provided by using an example in which the movable terminal 440 vibrates downward. When the movable terminal 440 vibrates downward, in some embodiments, the piezoelectric sensing component 442 may be arranged in a region with a relatively large compressive stress. For example, the piezoelectric sensing component 442 may be arranged at portions, close to the fixed terminal 420, on both ends of the movable terminal 440, and within a range in which a distance between the piezoelectric sensing component 442 and the fixed terminal 420 is less than a quarter of a length of the movable terminal 440. That is, the first region may be located at both ends of the movable terminal 440 and within a range in which a distance between the first region and the fixed terminal 420 is less than a quarter of the length of the movable terminal 440. For example, the movable terminal 440 may include at least two piezoelectric sensing components 442. An example in which there are two piezoelectric sensing components 442 is used for description. The two piezoelectric sensing components 442 may be respectively close to both ends of the fixed terminal 420, and a distance between each piezoelectric sensing component 442 and an end, close to the piezoelectric sensing component 442, of the fixed terminal 420 may be less than 1/4 of the length of the movable terminal 440. In this case, both ends of each piezoelectric sensing component 442 are connected to the fixed terminal 420 and the connecting beam 444, respectively.

In some embodiments, when the movable terminal 440 vibrates downward, the piezoelectric sensing component 442 may be arranged in a region with a relatively large tensile stress. For example, the piezoelectric sensing component 442 may be arranged on the movable terminal 440, and a distance between the piezoelectric sensing component 442 and one end of the fixed terminal 420 is within a range from one quarter to three quarters of the length of the movable terminal 440. That is, the first region may be on the movable terminal 440, and a distance between the first region and one end of the fixed terminal 420 is within a range from one quarter to three quarters of the length of the movable terminal 440.

It should be noted that the distance between the piezoelectric sensing component 442 and the fixed terminal 420 may be a distance from any position on the piezoelectric sensing component 442 to the fixed terminal 420. For example, the distance between the piezoelectric sensing component 442 and the fixed terminal 420 may be a distance between a center position of the piezoelectric sensing component 442 and the fixed terminal 420, or may be a distance between an end (any end) of the piezoelectric sensing component 442 and the fixed terminal 420, or may be a distance between another position of the piezoelectric sensing component 442 and the fixed terminal 420.

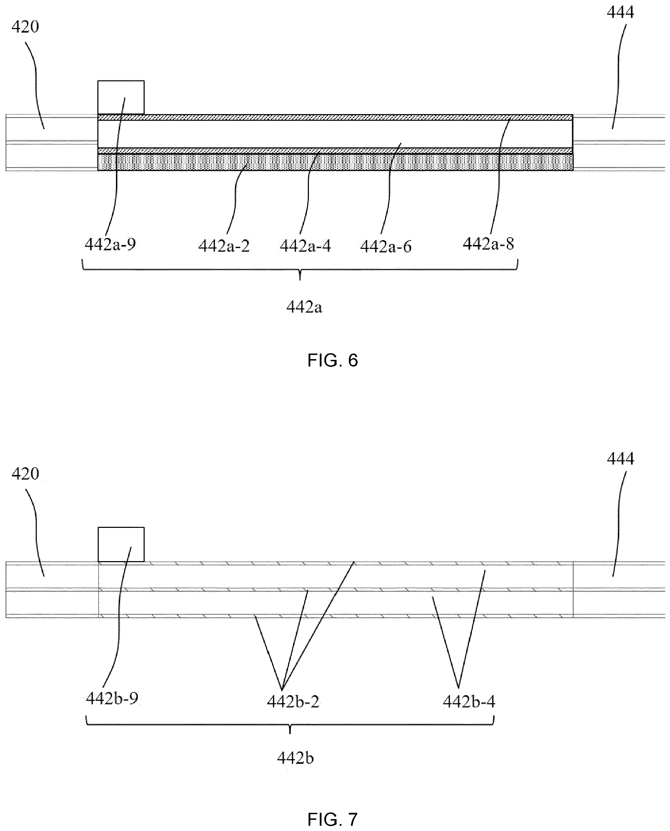

The piezoelectric sensing component 442 may include at least one of a laminated structure composed of a piezoelectric single crystal structure(s) and a laminated structure composed of a piezoelectric twin structure(s). In some embodiments, the piezoelectric sensing component 442 may be the laminated structure composed of the piezoelectric single crystal structure. FIG. 6 is a schematic diagram showing that the piezoelectric sensing component 442 is a piezoelectric single crystal structure 442a according to some embodiments of this specification. In some embodiments, the piezoelectric single crystal structure 442a may include an elastic layer 442a-2, a bottom electrode layer 442a-4, a piezoelectric layer 442a-6, and a top electrode layer 442a-8 in order from bottom to top along a thickness direction of the piezoelectric sensing component 442. In some embodiments, the piezoelectric single crystal structure 442a may include an elastic layer 442a-2, a top electrode layer 442a-8, a piezoelectric layer 442a-6, and a bottom electrode layer 442a-4 in order from top to bottom along the thickness direction of the piezoelectric sensing component 442. For ease of presentation, an example in which the piezoelectric single crystal structure 442a includes the elastic layer 442a-2, the bottom electrode layer 442a-4, the piezoelectric layer 442a-6, and the top electrode layer 442a-8 in order from bottom to top along the thickness direction of the piezoelectric sensing component 442 is used for description. In some embodiments, the piezoelectric single crystal structure 442a may further include a connection terminal layer 442a-9.

The elastic layer 442a-2 may be fixedly connected to the fixed terminal 420 and the connecting beam 444 directly or indirectly. The connection may be implemented in any manner, for example, a fixed connection manner such as welding, riveting, clamping, or bolting, or a deposition manner such as physical deposition (for example, physical vapor deposition) or chemical deposition (for example, chemical vapor deposition). When the vibration beam 400 receives vibrational excitation from the outside, the elastic layer 442a-2 may generate deformation based on the vibrational excitation. The elastic layer 442a-2 may be made of a material that is easily deformed under action of an external force. The elastic layer 442a-2 may be of a structure that is easily deformed and made of a semiconductor material. The elastic layer 442a-2 may be a single-layer material, such as Si, $SiO_2$, SiNx, or SiC, or may be a multi-layer material, such as Si/$SiO_2$, $SiO_2$/Si, Si/SiNx, or SiNx/Si. A thickness of the elastic layer 442a-2 may range from 1 $\mu$m to 10 $\mu$m. In some embodiments, the thickness of the elastic layer 442a-2 may range from 1 $\mu$m to 3 $\mu$m. In some embodiments, the thickness of the elastic layer 442a-2 may range from 2 $\mu$m to 6 $\mu$m. In some embodiments, the thickness of the elastic layer 442a-2 may range from 4 $\mu$m to 8 $\mu$m. In some embodiments, the thickness of the elastic layer 442a-2 may range from 6 $\mu$m to 10 $\mu$m.

The piezoelectric sensing component 442 may include a piezoelectric layer 442a-6. The piezoelectric layer 442a-6 is a structure that may generate, under the action of an external force, a voltage on two end surfaces. The piezoelectric layer 442a-6 may be fixedly connected to the base 200 directly or indirectly. The connection may be implemented in any manner, for example, a fixed connection manner such as welding, riveting, clamping, or bolting, or a deposition manner such as physical deposition (for example, physical vapor deposition) or chemical deposition (for example, chemical vapor deposition). In some embodiments, the piezoelectric layer 442a-6 may generate the deformation when receiving a vibration signal, and generate a voltage based on the deformation.

The piezoelectric layer 442a-6 may be attached to a surface of the elastic layer 442a-2 directly or indirectly. In some embodiments, the elastic layer 442a-2 may be connected to the fixed terminal 420 and the connecting beam 444, and the piezoelectric layer 442a-6 may be connected to the fixed terminal 420 and the connecting beam 444 through the elastic layer 442a-2. An example in which the vibration beam 400 is located on the upper surface of the base 200 is used for description. In some embodiments, the piezoelectric layer 442a-6 may be located on a side, away from the base 200, of the elastic layer 442a-2. In some embodiments, the piezoelectric layer 442a-6 may be located on a side, close to the base 200, of the elastic layer 442a-2. When the vibration beam 400 receives vibrational excitation from the outside, the elastic layer 442a-2 generates deformation based on the vibrational excitation. Based on a piezoelectric effect, the piezoelectric layer 442a-6 may be stressed under the action of the deformation of the elastic layer 442a-2, thereby generating a voltage (a potential difference).

A beam structure with bending deformation includes a cantilever beam, a simply supported beam, a fixed/clamped beam, and the like. When first-order bending deformation occurs on the beam structure, there is a neutral layer along a thickness direction, and materials on both sides of the neutral layer are in opposite stress states. For example, when the clamped beam is bent and deformed upwards, a support arm material of a part above the neutral layer is in a state of tensile stress, and a support arm material of a part below the neutral layer is in a state of compressive stress. Whether the positive or negative property of an output electrical signal of the piezoelectric material is related to the stress state. In order to maximize output efficiency of the piezoelectric material, the piezoelectric layer 442a-6 needs to be arranged on one side of the neutral layer.

A magnitude of the output electrical signal of the piezoelectric material is related to a magnitude of the stress. A distribution position of each layer of material in the thickness direction may affect stress distribution of each layer of material under same vibrational excitation. In some embodiments, the piezoelectric layer 442a-6 may be distributed on a side of the elastic layer 442a-2. Specifically, the piezoelectric layer 442a-6 is distributed on a position close to an upper surface or a lower surface of the vibration beam 400 in the thickness direction, so that the piezoelectric layer 442a-6 is far away from the neutral layer and the stress of the piezoelectric layer 442a-6 is maximized.

In some embodiments, the piezoelectric layer 442a-6 may be a piezoelectric polymer thin film obtained according to a semiconductor deposition process (for example, magnetron sputtering or MOCVD). In some embodiments, a material of the piezoelectric layer 442a-6 may include a piezoelectric crystal material and a piezoelectric ceramics material. The piezoelectric crystal material may be piezoelectric mono-crystal. In some embodiments, the piezoelectric crystal material may include quartz, sphalerite, boracite, tourmaline, zincite, GaAs, barium titanate and derived crystal thereof, $KH_2PO_4$,

$NaKC_4H_4O_6 \cdot 4H_2O$ (rochelle salt), or any combination thereof. The piezoelectric ceramics material may be piezoelectric poly-crystal formed through irregular collection of fine grains that are obtained after solid-phase reaction and sintering between powder particles of different materials. In some embodiments, the piezoelectric ceramics material may include barium titanate (BT), lead zirconate titanate (PZT), lithium lead barium niobate (PBLN), modified lead titanate (PT), aluminum nitride (AIN), zinc oxide (ZnO), or any combination thereof. In some embodiments, the material of the piezoelectric layer 442a-6 may alternatively be a piezoelectric polymer material, for example, polyvinylidene fluoride (PVDF). In some embodiments, a thickness of the piezoelectric layer 442a-6 may be greater than 500 nm. In some embodiments, the thickness of the piezoelectric layer 442a-6 may range from 20 $\mu$m to 500 $\mu$m, for example, when the vibration sensor 001 is used in a macroscopic device. In some embodiments, the thickness of the piezoelectric layer 442a-6 may range from 0.5 $\mu$m to 1.5 $\mu$m, for example, when the vibration sensor 001 is used in an MEMS device.

In some embodiments, a ratio of the thickness of the elastic layer 442a-2 to the thickness of the piezoelectric layer 442a-6 may be 1-10. In some embodiments, a ratio of the thickness of the elastic layer 442a-2 to the thickness of the piezoelectric layer 442a-6 may be 2-7.

The bottom electrode layer 442a-4 and the top electrode layer 442a-8 may be respectively distributed on surfaces on both sides of the piezoelectric layer 442a-6. The piezoelectric layer 442a-6 may be disposed between the bottom electrode layer 442a-4 and the top electrode layer 442a-8. The piezoelectric layer 442a-6 may deform with the deformation of the elastic layer 442a-2 under the action of a vibrational excitation from the outside, and generate a voltage under the action of deformation stress. The bottom electrode layer 442a-4 and the top electrode layer 442a-8 may collect the voltage to generate the electrical signal. The bottom electrode layer 442a-4 is positionally aligned with the top electrode layer 442a-8. As described above, the piezoelectric layer 442a-6 is connected to the elastic layer 442a-2, and distributed on a side of the elastic layer 442a-2. The bottom electrode layer 442a-4 may be distributed between the piezoelectric layer 442a-6 and the elastic layer 442a-2, and the top electrode layer 442a-8 may be distributed on a side, away from the elastic layer 442a-2, of the piezoelectric layer 442a-6.

In some embodiments, the bottom electrode layer 442a-4 and the top electrode layer 442a-8 may be structures of a conductive material. Exemplarily, the conductive material may include a metal, an alloy material, a metal oxide material, graphene, or the like, or any combination thereof. In some embodiments, the metal and the alloy material may include nickel, iron, lead, platinum, titanium, copper, molybdenum, zinc, or any combination thereof. In some embodiments, the alloy material may include a copper-zinc alloy, a copper-tin alloy, a copper-nickel-silicon alloy, a copper-chromium alloy, a copper-silver alloy, or any combination thereof. In some embodiments, the metal oxide material may include $RuO_2$, $MnO_2$, $PbO_2$, NiO, or the like, or any combination thereof.

The bottom electrode layer 442a-4 may include at least one bottom piezoelectric electrode slice. The top electrode layer 442a-8 may include at least one top piezoelectric electrode slice. Each of the at least one bottom piezoelectric electrode slice may be positionally aligned with at least one of the at least one top piezoelectric electrode slice. In some embodiments, each bottom piezoelectric electrode slice may positionally correspond to one top piezoelectric electrode slice. In some embodiments, each bottom piezoelectric electrode slice may positionally correspond to a plurality of top piezoelectric electrode slices, for example, 2, 3, 4, or another quantity of top piezoelectric electrode slices. The plurality of top piezoelectric electrode slices may use the bottom piezoelectric electrode slice as a common terminal to form output units connected in series, thereby increasing an output voltage, and improving sensitivity. The plurality of top piezoelectric electrode slices may alternatively form output units connected in parallel with the bottom piezoelectric electrode slice, thereby increasing an output charge, and improving sensitivity. The piezoelectric sensing component 442 may include only output units connected in series, only output units connected in parallel, or both output units connected in series and output units connected in parallel.

In some embodiments, a thickness of the bottom electrode layer 442a-4 may range from 50 nm to 200 nm. In some embodiments, the thickness of the bottom electrode layer 442a-4 may range from 100 nm to 150 nm. In some embodiments, the thickness of the bottom electrode layer 442a-4 may range from 100 nm to 200 nm. In some embodiments, the thickness of the bottom electrode layer 442a-4 may range from 80 nm to 150 nm. In some embodiments, the thickness of the bottom electrode layer 442a-4 may range from 150 nm to 200 nm. In some embodiments, the thickness of the bottom electrode layer 442a-4 may range from 120 nm to 150 nm. In some embodiments, the thickness of the bottom electrode layer 442a-4 may range from 120 nm to 200 nm. In some embodiments, the thickness of the bottom electrode layer 442a-4 may range from 150 nm to 200 nm. In some embodiments, a thickness of the top electrode layer 442a-8 may range from 50 nm to 200 nm. In some embodiments, the thickness of the top electrode layer 442a-8 may range from 100 nm to 150 nm. In some embodiments, the thickness of the top electrode layer 442a-8 may range from 100 nm to 200 nm. In some embodiments, the thickness of the top electrode layer 442a-8 may range from 80 nm to 150 nm. In some embodiments, the thickness of the top electrode layer 442a-8 may range from 150 nm to 200 nm. In some embodiments, the thickness of the top electrode layer 442a-8 may range from 120 nm to 150 nm. In some embodiments, the thickness of the top electrode layer 442a-8 may range from 120 nm to 200 nm. In some embodiments, the thickness of the top electrode layer 442a-8 may range from 150 nm to 200 nm.

In some embodiments, the piezoelectric single crystal structure 442a may further include a connection terminal layer 442a-9, which is connected to the bottom electrode layer 442a-4 or the top electrode layer 442a-8, to output the electrical signal to an external processing circuit. The connection terminal layer 442a-9 may or may not be of a same material as the bottom electrode layer 442a-4 and the top electrode layer 442a-8. In some embodiments, a thickness of the connection terminal layer 442a-9 may range from 100 nm to 200 nm. In some embodiments, the thickness of the connection terminal layer 442a-9 may range from 150 nm to 200 nm. In some embodiments, the thickness of the connection terminal layer 442a-9 may range from 100 nm to 150 nm. In some embodiments, the thickness of the connection terminal layer 442a-9 may range from 120 nm to 200 nm. In some embodiments, the thickness of the connection terminal layer 442a-9 may range from 160 nm to 200 nm.

In some embodiments, the piezoelectric sensing component 442 may be the laminated structure composed of the piezoelectric single crystal structure. FIG. 7 is a schematic diagram showing that the piezoelectric sensing component 442 is a piezoelectric twin structure 442b according to some embodiments of this specification. As shown in FIG. 7, the piezoelectric twin structure 442b may include an electrode layer 442b-2, a piezoelectric layer 442b-4, an electrode layer 442b-2, a piezoelectric layer 442b-4, and an electrode layer 442b-2 in order from bottom to top along a thickness direction of the piezoelectric sensing component 442. In some embodiments, the piezoelectric twin structure 442b may further include a connection terminal layer 442b-9. A material thickness of the electrode layer 442b-2 is basically the same as that of the bottom electrode layer 442a-4 or the top electrode layer 442a-8, and details are not described herein again. A material thickness of the piezoelectric layer 442b-4 is basically the same as that of the piezoelectric layer 442a-6, and details are not described herein again. A material thickness of the connection terminal layer 442b-9 is basically the same as that of the foregoing connection terminal layer 442a-9, and details are not described herein again.

The connecting beam 444 may be used to connect piezoelectric sensing components 442. For example, the connecting beam 444 may be located between two piezoelectric sensing components 442 and connect the two piezoelectric sensing components 442. A material of the connecting beam 444 may be Si, $SiO_2$, SiNx, or the like.

As show in FIG. 1 to FIG. 5, to improve sensitivity of the vibration sensor 001, each vibration beam 400 may further include a counterweight 460. The counterweight 460 may be connected to the movable terminal 440. The counterweight 460 may be connected to the movable terminal 440 directly or indirectly. Specifically, the counterweight 460 may be connected to the connecting beam 444. In some embodiments, the counterweight 460 may be located in the middle of the movable terminal 440, so that the counterweight 460 may be located in the center of the cavity 220 in the first direction 221. When the movable terminal 440 generates deformation in response to external vibrational excitation, the counterweight 460 may be displaced based on the deformation. In some embodiments, the counterweight 460 may protrude sideward relative to the movable terminal 440, and be suspended in the cavity 220. For example, the counterweight 460 may protrude upwards relative to the movable terminal 440, and be suspended in the cavity 220. The counterweight 460 may alternatively protrude downwards relative to the movable terminal 440, and be suspended in the cavity 220.

The counterweight 460 may make the movable terminal 440 more easily deformed under the action of an external force, thereby enhancing the electrical signal output by the piezoelectric sensing component 442. In some embodiments, the electrical signal output by the piezoelectric sensing component 442 may be increased by changing a dimension, a shape, or a position of the counterweight 460. Natural frequency and vibration amplitude of the vibration beam 400 during vibration may be changed by disposing the counterweight 460.

In some embodiments, a material of the counterweight 460 may be Si, $SiO_2$, SiNx, or the like. A planar shape of the counterweight 460 may be a circle, a triangle, a quadrangle, a polygon, or the like. An example in which the planar shape of the counterweight 460 is a quadrangle is used for description. In some embodiments, a length of the counterweight 460 may range from 50 $\mu$m to 500 $\mu$m. In some embodiments, the length of the counterweight 460 may range from 80 $\mu$m to 300 $\mu$m. In some embodiments, a width of the counterweight 460 may range from 50 $\mu$m to 500 $\mu$m. In some embodiments, the width of the counterweight 460 may range from 80 $\mu$m to 200 $\mu$m. In some embodiments, the width of the counterweight 460 may be greater than, equal to, or less than a width of the vibration beam 400. In some embodiments, the width of the counterweight 460 may be equal to the width of the vibration beam 400.

Because the counterweight 460 is in rigid connection with the movable terminal 440, deformation, corresponding to a position where the counterweight 460 is disposed, of the movable terminal 440 is relatively small, and a voltage of an available electrical signal is relatively low. However, deformation and stress, at a position close to the counterweight 460, of the movable terminal 440 are relatively large, and the voltage of the available electrical signal is relatively large. Therefore, in some embodiments, for the vibration sensor 001, a piezoelectric sensing component 442 may be additionally added near the counterweight 460. The additionally added piezoelectric sensing component 442 may be disposed in a circumferential region close to the counterweight 460 and around the counterweight 460.

In some embodiments, when the vibrational excitation is a mechanical vibrational excitation (for example, when the vibration sensor 001 is used in a bone-conduction microphone), each vibration beam 400 may include a counterweight 460. In some embodiments, when the vibrational excitation is an air vibrational excitation (for example, when the vibration sensor 001 is used in an air-conduction microphone), each vibration beam 400 may not include a counterweight 460.

As described above, the dimension of the cavity 220 in the first direction 221 may vary along the second direction 222. That is, the dimension of the cavity 220 in the first direction 221 changes as its position in the second direction 222 changes. In other words, the cavity 220 has different dimensions in the first direction 221 when the cavity 220 is at different positions in the second direction 222. The plurality of vibration beams 400 may be sequentially arranged on the base 200 along the second direction 222. The movable terminal 440 of each vibration beam 400 is suspended in the cavity 220. In other words, the plurality of vibration beams 400 can be respectively located at different positions, in the second direction 222, of the cavity 220. Therefore, a portion where the movable terminal 440 of each vibration beam 400 is suspended in the cavity 220 has a different dimension (axial dimension of the vibration beam 400) in the first direction 221. Therefore, each vibration beam 400 has a different natural frequency. The plurality of vibration beams 400 correspond to a plurality of vibration frequencies. Each vibration beam 400 generates, in response to external vibrational excitation, a vibration signal in a sub-target frequency window including a natural frequency corresponding to the vibration beam. The vibration signals generated by different vibration beams 400 correspond to different sub-target frequency windows. A plurality of sub-target frequency windows corresponding to the plurality of vibration beams 400 cover different frequency ranges, and the plurality of sub-target frequency windows constitute a target frequency window. In some embodiments, the target frequency window may be a consecutive frequency window. The plurality of sub-target frequency windows together can constitute a continuous target frequency window. In some embodiments, the target frequency window may be any frequency range. The target frequency window may be set based on a usage scenario of the vibration sensor 001. For example, the target frequency window may be different for the vibration sensor 001 used as a microphone and as an acceleration sensor. In some embodiments, a plurality of natural frequencies corresponding to the plurality of vibration beams 400 may be evenly distributed within the target frequency window. In some embodiments, the plurality of natural frequencies corresponding to the plurality of vibration beams 400 may not be evenly distributed within the target frequency window.

As mentioned above, the sub-target frequency window may be a frequency window including the natural frequency. In some embodiments, the sub-target frequency window may be a frequency window set symmetrically with respect to the natural frequency. In some embodiments, the sub-target frequency window may be a frequency window set asymmetrically with respect to the natural frequency. In some embodiments, a length range of the sub-target frequency window should be within a preset length range. In some embodiments, a range covered by the sub-target frequency window may be determined based on an amplitude of a vibration signal corresponding to the sub-target frequency window. For example, the amplitude of the vibration signal in the sub-target frequency window should not be less than a preset proportion of a resonance peak corresponding to the natural frequency. The preset proportion may be any preset proportion, such as 20%, 30%, and 50%. In some embodiments, the range covered by the sub-target frequency window may be determined based on sensitivity of the vibration signal corresponding to the sub-target frequency window. For example, the sensitivity of the vibration signal in the sub-target frequency window should not be less than a preset threshold.

In some embodiments, a range of a target frequency window corresponding to the vibration sensor 001 may be determined according to a usage scenario and usage requirements of the vibration sensor 001, so as to determine a quantity of the plurality of vibration beams 400, and a natural frequency and a sub-target frequency window that are corresponding to each vibration beam 400. In some embodiments, when the vibration sensor 001 is used as a microphone (such as a bone-conduction microphone), the target frequency window may range from 100 Hz to 5000 Hz. In some embodiments, the target frequency window of the vibration sensor 001 may range from 20 Hz to 5000 Hz. In some embodiments, there may be two or more vibration beams 400. For example, in some embodiments, the quantity of the vibration beams 400 may range from 3 to 50. In some embodiments, the quantity of the vibration beams 400 may range from 10 to 20. In some embodiments, the quantity of the vibration beams 400 may be determined according to a usage scenario and usage requirements of the vibration sensor 001 and based on a quantity of resonance peaks required by the vibration sensor 001. In a case where only first-order resonance peaks of the vibration beams 400 are used, the quantity of vibration beams 400 is equal to the quantity of resonance peaks. In a case where high-order resonance peaks of the vibration beams 400 are used, the quantity of vibration beams 400 is less than the quantity of resonance peaks. However, a signal strength of a high-order resonance peak is usually much less than that of a first-order resonance peak, so that the first-order resonance peak of the vibration beam 400 is usually used in the vibration sensor 001.

The natural frequency of the vibration beam 400 is determined by characteristics of the vibration beam 400. The natural frequency of the vibration beam 400 is not only related to a material property of the vibration beam 400, but also related to a dimension of the movable terminal 440, suspended in the cavity 200, of the vibration beam 400. As mentioned above, the cavity 220 has different dimensions in the first direction 221 when the cavity 220 is at different positions in the second direction 222. Therefore, each vibration beam 400 may be designed based on a dimension of the cavity 220 in the first direction 221, a connection position of each vibration beam 400 on the cavity 220, and a dimension of each vibration beam 400, so that a natural frequency of each vibration beam 400 satisfies a preset value. Specifically, the movable terminal 440 of each vibration beam 400 suspended in the cavity 220 satisfies a preset rule by changing the dimension of the cavity 220 in the first direction 221, the connection position of each vibration beam 400 on the cavity 220, and the dimension of each vibration beam 400, so that the natural frequency of each vibration beam 400 satisfies the preset value. The preset value may be a predetermined natural frequency of each vibration beam 400.

In some embodiments, overall dimensions of the plurality of vibration beams 400 may be the same. For example, the vibration beams 400 may have a same axial length, a same width, and a same thickness. The movable terminals 440, suspended in the cavity 220, of the plurality of vibration beams 400 may have different dimensions by changing a connection position of each vibration beam 400 on the cavity 220 and a dimension of the cavity 220 in the first direction 221, so that the plurality of vibration beams 400 have different natural frequencies, and the natural frequencies satisfies the preset value. In this case, there is no need to customize the dimension of each vibration beam 400. A design of the natural frequencies of the plurality of vibration beams 400 may be realized and the natural frequencies satisfies the preset value only by changing the dimension of the cavity 220 and the connection position of each vibration beam 400 on the cavity 220. This method may reduce a processing difficulty and processing costs, and also improve precision of the vibration sensor 001.

In some embodiments, the overall dimensions of the plurality of vibration beams 400 may be different. For example, dimensions in at least one direction of the axial length, width, and thickness of the vibration beams 400 may be different. The movable terminals 440, suspended in the cavity 220, of the plurality of vibration beams 400 may have different dimensions by changing a connection position of each vibration beam 400 on the cavity 220, a dimension of the cavity 220 in the first direction 221, and dimensions of the plurality of vibration beams 400, so that the plurality of vibration beams 400 have different natural frequencies, and the natural frequencies satisfies the preset value.

For ease of description, an example in which the overall dimensions of the plurality of vibration beams 400 are the same is used for description.

For example, an example in which the target frequency window ranges from 20 Hz to 5000 Hz, a quantity of the vibration beams 400 is 10, and natural frequencies of the 10 vibration beams 400 are evenly distributed in the target frequency window is used for description. A frequency band width is required between the natural frequencies of the vibration beams 400 for differentiation, and the frequency band width between the natural frequencies may range from 50 Hz to 400 Hz. In some embodiments, the frequency band width between the natural frequencies may range from 100 Hz to 200 Hz. In some embodiments, a gap width between the vibration beams 400 may range from 1 μm to 200 μm. In some embodiments, the gap width between the vibration beams 400 may range from 10 μm to 100 μm. The gap widths between different vibration beams 400 may or may not be equal.

In some embodiments, a length of the movable terminal 440, suspended above the cavity 220, of each vibration beam 400 in the first direction 221 may vary linearly or non-linearly. In some embodiments, the vibration beams 400 may be arranged in sequence on the cavity 220 according to the length of the movable terminal 440, or may be arranged according to another rule. A planar shape of each vibration beam 400 may be a rectangle, a trapezoid, a curve, or the like. In some embodiments, a cross-sectional width of each vibration beam 400 may range from 50 μm to 300 μm. In some embodiments, the cross-sectional width of each vibration beam 400 may range from 80 μm to 200 μm. In some embodiments, an axial length of each vibration beam 400 may range from 100 μm to 1300 μm. In some embodiments, the axial length of each vibration beam 400 may range from 200 μm to 1200 μm.

As described above, in some embodiments, the vibration beam 400 may not include a counterweight 460. For example, in an air-conduction microphone, since energy of air vibrational excitation is small, gap widths between adjacent vibration beams 400 may be reduced to increase an output of a vibration signal.

In some embodiments, the vibration beam 400 may further include a counterweight 460. In this case, each vibration beam 400 may be designed based on a dimension of the cavity 220 in the first direction 221, a connection position of each vibration beam 400 on the cavity 220, a dimension of each vibration beam 400, and a dimension of the counterweight 460, so that a natural frequency of each vibration beam 400 satisfies a preset value. Specifically, the movable terminal 440 of each vibration beam 400 suspended in the cavity 220 may satisfy a preset rule by changing the dimension of the cavity 220 in the first direction 221, the connection position of each vibration beam 400 on the cavity 220, the dimension of each vibration beam 400, and the dimension of the counterweight 460, so that the natural frequency of each vibration beam 400 satisfies the preset value.

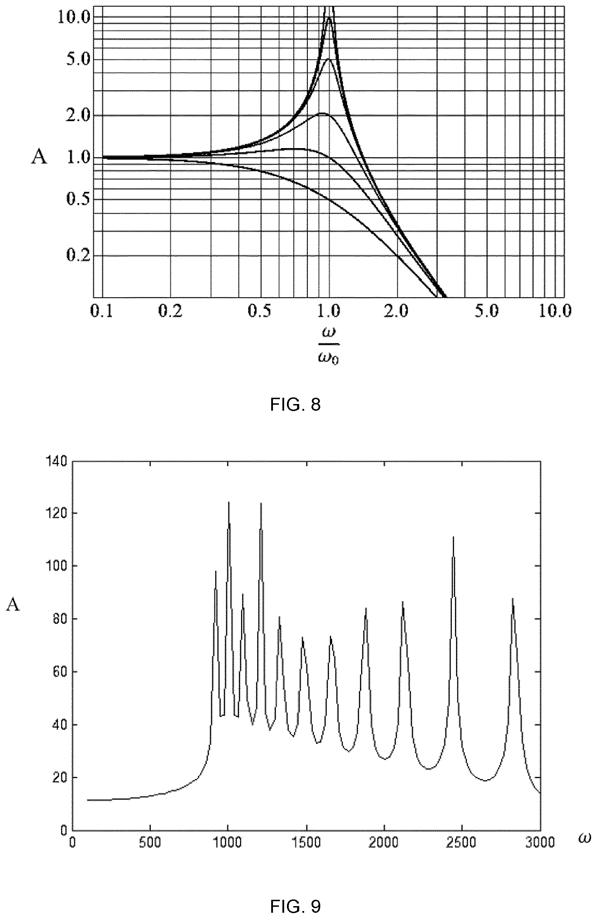

FIG. 8 is a normalized displacement resonance graph according to some embodiments of this specification. The graph shown in FIG. 8 may be a normalized displacement resonance graph corresponding to one of a plurality of vibration beams 400. As shown in FIG. 8, a horizontal axis is a ratio of external vibrational excitation $\omega$ to a natural frequency $\omega_0$ of the vibration beam 400, and a vertical axis is a normalized displacement A. The normalized displacement A may be a ratio of a displacement amplitude to a static displacement amplitude of the vibration beam 400. The static displacement amplitude may be a displacement amplitude obtained when the external vibrational excitation is constant excitation (namely, $\omega = 0$), where $\omega_0 = \sqrt{\dfrac{K}{M}}$. M is a mass of the vibration beam 400, namely, a mass of a movable terminal 440 and a counterweight 460; and K is an elastic coefficient of the vibration beam 400. As shown in FIG. 8, when the natural frequency $\omega_0$ of the vibration beam 400 is equal to the external vibrational excitation $\omega$, the normalized displacement A reaches the maximum, that is, a displacement at resonance frequency reaches a peak value (namely, a resonance peak). Therefore, in order to improve sensitivity of the vibration sensor 001, for a vibration signal collected by the piezoelectric sensing component 442, a preset frequency range near the natural frequency $\omega_0$ of the vibration beam 400 may be selected as a sub-target frequency window corresponding to each vibration beam 400, and a vibration signal in the sub-target frequency window may be used as a vibration signal generated by the vibration beam 400.

Different curves shown in FIG. 8 correspond to six different mechanical quality factors Q of the vibration beam 400, respectively, where $Q = \dfrac{\omega_0 M}{R}$, and R denotes a damping of the vibration beam 400. As shown in FIG. 8, when the natural frequency $\omega_0$ of the vibration beam 400 is determined, the greater the mechanical quality factor Q of the vibration beam 400, the larger a corresponding normalized displacement A. A larger electrical signal of the vibration signal may be output by the piezoelectric sensing component 442 corresponding to the normalized displacement A.

When there is a plurality of vibration beams 400 on the base 200, vibration signals generated by the plurality of vibration beams 400 may be coupled and superimposed with each other. If a stiffness and a mass of the base 200 are much greater than those of the vibration beam 400, a coupling effect between different vibration beams 400 may be ignored. That is, it may be considered that linear superposition is performed on electrical signals of the vibration signals output by the vibration sensor 001. FIG. 9 is a schematic diagram of a vibration signal according to some embodiments of this specification. The vibration signal shown in FIG. 9 is obtained through linear superposition of a plurality of vibration signals generated by a plurality of vibration beams 400. In some embodiments, to facilitate subsequent signal processing, a deviation of each vibration signal output by different vibration beams 400 may be within a preset deviation range on a natural frequency corresponding to the vibration signal, so that each vibration signal output by different vibration beams 400 may be in a same or similar order of magnitude on the natural frequency corresponding to the vibration signal to facilitate calculation. The preset deviation range may be a preset range that is convenient for signal calculation. The preset deviation range may be obtained based on experience, may be obtained based on experimental statistics, or may be obtained based on machine learning. The deviation of each vibration signal output by different vibration beams 400 being within a preset deviation range on a natural frequency corresponding to the vibration signal may be that a deviation of a normalized displacement A of the vibration signals output by the different vibration beams 400 does not exceed the preset deviation range on the corresponding natural frequency. In some embodiments, the preset deviation range may be any value, such as $\pm30\%$, $\pm20\%$, or $\pm10\%$. In some embodiments, a mechanical quality factor Q of each vibration beam 400 may be designed, so that a deviation of each mechanical quality factor Q of the plurality of vibration beams 400 is within a preset deviation range, and thus the deviation of the normalized displacement A of the vibration signals output by the different vibration beams 400 is within the preset deviation range on the corresponding natural frequency. In some embodiments, the counterweight 460 may be matched with the natural frequency of the vibration beam 400 corresponding to the counterweight 460 by designing a dimension of the counterweight 460, so that the deviation of the mechanical quality factor Q of each vibration beam 400 is within the preset deviation range, and thus a deviation of the vibration signal corresponding to each vibration beam 400 is within the preset deviation range on the corresponding natural frequency. Specifically, on the premise of determining the natural frequency $\omega_0$ of each vibration beam 400, the deviation of the mechanical quality factor Q of each vibration beam 400 may be within the preset deviation range by designing and changing the dimension of the cavity 220 in the first direction 221, the connection position of each vibration beam 400 on the cavity 220, the dimension of the movable terminal 440, and the dimension of the counterweight 460, so that the deviation of the vibration signal corresponding to each vibration beam 400 is within the preset deviation range on the natural frequency corresponding to the vibration beam 400.

In some embodiments, the deviation of the normalized displacement A of the vibration signals output by different vibration beams 400 may alternatively be not within the preset deviation range on the corresponding natural frequencies. Those skilled in the art should understand that the normalized displacement A of the vibration signals output by different vibration beams 400 being not within the preset deviation range on the corresponding natural frequencies does not affect superposition processing of the vibration signals, which also falls within the protection scope of this specification.

This specification further provides a microphone. The microphone may include a housing and the vibration sensor 001 provided in this specification. The vibration sensor 001 may be mounted in the housing. The housing may be fixedly connected to the base 200. The housing and the base 200 may be integrated, or may be formed separately and fixedly connected in a manner such as welding, riveting, bolting, or bonding. When the housing vibrates under action of an external force (for example, when a person speaks, face vibration drives the housing to vibrate), the vibration of the housing drives the base 200 to vibrate. Because the vibration beam 400 and the housing structure (or the base 200) have different attributes, movement of the vibration beam 400 and movement of the housing structure (or the base 200) fails to keep completely consistent, thereby generating relative movement, and further causing the vibration beam 400 to generate the deformation. The piezoelectric sensing component 442 may convert the deformation into the vibration signal, and output the vibration signal.

In some embodiments, the microphone may further include a signal synthesizing circuit. The signal synthesizing circuit may be connected to the piezoelectric sensing component 442 of each vibration beam 400 and configured to collect the vibration signal of each piezoelectric sensing component 442 during operation and perform signal synthesis processing, to generate a vibration signal within a target frequency window. The signal synthesis processing may refer to performing linear superposition on a plurality of vibration signals generated by the plurality of vibration beams 400.

As exemplarily description, the microphone described in this specification may be applied to various electronic products, such as earphones (for example, bone-conduction earphones or air-conduction earphones, wireless earphones, or wired earphones), smart glasses, a smart wearable device, a smart helmet, a smart watch, or another device that has a voice collection function.

In conclusion, according to the vibration sensor 001 and the microphone provided in this specification, a vibration beam 400 is fixed on a base 200 through a fixed terminal 420 at both ends, and a movable terminal 440 of a middle portion is suspended in a cavity 220 and generates deformation in response to external vibrational excitation. According to the vibration sensor 001 and the microphone, portions, suspended in the cavity 220, of a plurality of vibration beams 400 may have different dimensions by changing a structure and a dimension of the cavity 220 and a dimension and a connection position of each vibration beam 400, so that different vibration beams 400 may have different natural frequencies, and resonance peaks of different frequencies may be generated under vibrational excitation. The plurality of vibration beams 400 may generate a vibration signal with a plurality of different frequency ranges, and the vibration signal with the plurality of different frequency ranges may together constitute a vibration signal with a wide frequency band, making the vibration sensor 001 have a wider frequency response range. In addition, a vibration signal selected by the vibration sensor 001 and the microphone may be a vibration signal within a preset range near the resonance peak, so that sensitivity may be higher. Moreover, in the vibration sensor 001 and the microphone, a dimension of the cavity 220 of the base 200 may be designed to realize multi-resonance peaks and a wide frequency band. The structure may be simple, processing difficulty may be low, processing costs may be low, and a more accurate collection result of the vibration signal may be obtained. In addition, based on the vibration signal collected by the vibration sensor 001 and the microphone 002 provided in this specification, in subsequent processing of the vibration signal, a displacement signal output at different frequencies with a steep cut-off edge may be extracted from the vibration signal shown in FIG. 9 by using a low-order filter during later algorithm processing, so that input signals in different frequencies are extracted, thereby avoiding use of a high-order filter for extracting the signals in later algorithm and reducing a calculation amount of the algorithm.

The above describes specific embodiments of this specification. Other embodiments are within the scope of the appended claims. In some cases, the actions or steps described in the claims may be performed in an order different from that in the embodiments and a desired result can still be achieved. In addition, the processes described in the accompanying drawings are not necessarily required to achieve a desired result in a specific order or a continuous order shown. In some implementations, multiple-task processing and parallel processing are also possible or may be advantageous.

In conclusion, after reading this detailed disclosure, those skilled in the art may understand that the foregoing detailed disclosure may be presented by way of example only, and may not be restrictive. Although it is not explicitly stated herein, those skilled in the art may understand that this specification needs to cover various reasonable changes, improvements, and modifications of the embodiments. These changes, improvements, and modifications are intended to be proposed in this specification, and are within the spirit and scope of the exemplary embodiments of this specification.

In addition, some terms in this specification have been used to describe the embodiments of this specification. For example, "one embodiment", "an embodiment", and/or "some embodiments" mean that specific features, structures, or characteristics described in combination with the embodiments may be included in at least one embodiment of this specification. Therefore, it may be emphasized and should be understood that two or more references to " embodiments", "an embodiment", or "an alternative embodiment" in various parts of this specification do not necessarily all refer to the same embodiment. In addition, specific features, structures, or characteristics may be appropriately combined in one or more embodiments of this specification.

It should be understood that in the foregoing description of the embodiments of this specification, to facilitate understanding of a feature, for the purpose of simplifying this specification, various features may be combined in a single embodiment, an accompanying drawing, or description thereof in this specification. However, this does not indicate that the combination of these features is necessary. It is entirely possible for those skilled in the art to extract some of these features as a separate embodiment for understanding when reading this specification. In other words, the embodiments in this specification may also be understood as integration of a plurality of secondary embodiments. The same is also true when content of each secondary embodiment contains features less than all the features of a separate embodiment disclosed above.

Each patent, patent application, publication of a patent application, and another material referenced in this specification, such as an article, a book, a specification, a print, a document, or an object, may be incorporated herein by reference. All content used for all purposes, except for any related litigation document history, history of any identical litigation document inconsistent with or in conflict with this document, or history of any identical litigation document that may have a restrictive effect on the widest scope of the claims may be associated with this document at present or in the future. For example, if there is any inconsistency or conflict between description, definition, and/or use of terms related to any material contained in this document and description, definition, and/or use of terms related to this document, the terms in this document prevail.

Finally, it should be understood that an implementation of the application disclosed in this document is used to describe a principle of an implementation of this specification. Other modified embodiments also fall within the scope of this specification. Therefore, the embodiments disclosed in this specification are only examples but not limitations. Those skilled in the art may implement the application in this specification by using an alternative configuration of the embodiments in this specification. Therefore, the embodiments of this specification are not limited to the embodiments described accurately in this application.

**Claims**

1. A vibration sensor, **characterized in that** the vibration sensor comprises:

    a base, including a cavity; and
    a plurality of vibration beams, sequentially arranged on the base, wherein each vibration beam includes:

        a fixed terminal, including two parts respectively located at two ends of the vibration beam and connected to the base, and
        a movable terminal, connected to the fixed terminal, located between the two parts of the fixed terminal, and suspended in the cavity, wherein
        a portion, suspended in the cavity, of each vibration beam has a different dimension and a different natural frequency, and each vibration beam generates, in response to an external vibrational excitation, a vibration signal in a sub-target frequency window including a natural frequency corresponding to the vibration beam.

2. The vibration sensor according to claim 1, **characterized in that** a plurality of sub-target frequency windows corresponding to the plurality of vibration beams cover different frequency ranges, and the plurality of sub-target frequency windows constitutes a target frequency window.

3. The vibration sensor according to claim 2, **characterized in that** a plurality of natural frequencies corresponding to the plurality of vibration beams are evenly distributed within the target frequency window.

4. The vibration sensor according to claim 1, **characterized in that** a dimension of the cavity in a first direction changes along a second direction, the plurality of vibration beams are arranged on the base along the second direction, and the fixed terminal are connected to the base along the first direction.

5. The vibration sensor according to claim 4, **characterized in that** the dimension of the cavity in the first direction, a connection position of each vibration beam on the cavity, and a dimension of each vibration beam satisfy a preset rule, so that the natural frequency of each vibration beam satisfies a preset value.

6. The vibration sensor according to claim 4, **characterized in that** the movable terminal generates deformation in response to the vibrational excitation, and the movable terminal includes:

    a piezoelectric sensing component, configured to convert the deformation into the vibration signal, wherein the vibration signal includes an electrical signal; and
    a connecting beam, connected to the piezoelectric sensing component.

7. The vibration sensor according to claim 6, **characterized in that** a distance between the piezoelectric sensing component and one end of the fixed terminal ranges from one quarter to three quarters of a length of the movable terminal.

8. The vibration sensor according to claim 6, **characterized in that** the movable terminal includes:
two piezoelectric sensing components, respectively close to two ends of the fixed terminal, and a distance between each piezoelectric sensing component and the fixed terminal close thereto is less than 1/4 of a length of the movable terminal.

9. The vibration sensor according to claim 6, **characterized in that** the piezoelectric sensing component includes at least one of a piezoelectric single crystal structure, or a piezoelectric twin structure.

10. The vibration sensor according to claim 1, **characterized in that** each vibration beam further includes:
a counterweight, connected to the movable terminal, wherein the movable terminal generates deformation in response to the vibrational excitation, and the counterweight is displaced based on the deformation.

11. The vibration sensor according to claim 10, **characterized in that** a dimension of the cavity in a first direction, a connection position of each vibration beam on the cavity, a dimension of each vibration beam, and a dimension of the counterweight satisfy a preset rule, so that the natural frequency of each vibration beam satisfies a preset value.

12. The vibration sensor according to claim 11, **characterized in that** the dimension of the counterweight is matched with the natural frequency of the vibration beam corresponding to the counterweight, so that a deviation of the vibration signals on the natural frequencies corresponding to the plurality of vibration beams is within a preset deviation range.

13. A microphone, **characterized in that** the microphone comprises:

> a housing;
> the vibration sensor according to any one of claims 1 to 12, wherein the vibration sensor is mounted in the housing, and the base is fixedly connected to the housing; and
> a signal synthesizing circuit, connected to the plurality of vibration beams and configured to collect the vibration signals during operation and perform signal synthesis on the vibration signals, to generate a vibration signal within a target frequency window, wherein a plurality of sub-target frequency windows corresponding to the plurality of vibration beams cover different frequency ranges, and the plurality of sub-target frequency windows constitutes the target fre-

quency window.

<u>**001**</u>

FIG. 1

FIG. 2

FIG. 3

FIG. 4

A-A

**001**

400

420                    440                    420

442        444              442

460

200        220

FIG. 5

420

444

442a-9    442a-2    442a-4    442a-6    442a-8

442a

FIG. 6

420

444

442b-9    442b-2    442b-4

442b

FIG. 7

FIG. 8

FIG. 9

## INTERNATIONAL SEARCH REPORT

| | International application No. |
|---|---|
| | **PCT/CN2022/094006** |

### A. CLASSIFICATION OF SUBJECT MATTER

H04R 1/22(2006.01)i; H04R 17/10(2006.01)i

According to International Patent Classification (IPC) or to both national classification and IPC

### B. FIELDS SEARCHED

Minimum documentation searched (classification system followed by classification symbols)

H04R1/-;H04R17/-;H04R19/-

Documentation searched other than minimum documentation to the extent that such documents are included in the fields searched

Electronic data base consulted during the international search (name of data base and, where practicable, search terms used)

CNABS; CNTXT; ENTXTC; CNKI: 振动传感器, 腔, 谐振, 共振, 臂, 梁, 宽度, 长度, 尺寸, 频率, 配重块, 质量块, 麦克风, 拾音器; VEN; ENTXT; USTXT: vibration sensor, cavity, arm, beam+, resonan+, natural frequenc+, size, width, breadth, bength, proof mass+, weight+

### C. DOCUMENTS CONSIDERED TO BE RELEVANT

| Category* | Citation of document, with indication, where appropriate, of the relevant passages | Relevant to claim No. |
|---|---|---|
| X | CN 113330754 A (HEMIDEINA PTY LTD.) 31 August 2021 (2021-08-31) description, paragraphs 64-72, and figures 1-5 | 1-9, 13 |
| Y | CN 113330754 A (HEMIDEINA PTY LTD.) 31 August 2021 (2021-08-31) description, paragraphs 64-72, and figures 1-5 | 10-12 |
| Y | CN 111050256 A (WUHAN UNIVERSITY) 21 April 2020 (2020-04-21) description, paragraph 14 | 10-12 |
| A | US 2017156002 A1 (APPLE INC.) 01 June 2017 (2017-06-01) entire document | 1-13 |
| A | CN 201216021 Y (TRANSOUND ELECTRONICS CO., LTD.) 01 April 2009 (2009-04-01) entire document | 1-13 |
| A | CN 114079841 A (SAMSUNG ELECTRONICS CO., LTD.) 22 February 2022 (2022-02-22) entire document | 1-13 |
| A | CN 106034276 A (SAMSUNG ELECTRONICS CO., LTD.) 19 October 2016 (2016-10-19) entire document | 1-13 |

☐ Further documents are listed in the continuation of Box C.   ☑ See patent family annex.

| * | Special categories of cited documents: |
|---|---|
| "A" | document defining the general state of the art which is not considered to be of particular relevance |
| "E" | earlier application or patent but published on or after the international filing date |
| "L" | document which may throw doubts on priority claim(s) or which is cited to establish the publication date of another citation or other special reason (as specified) |
| "O" | document referring to an oral disclosure, use, exhibition or other means |
| "P" | document published prior to the international filing date but later than the priority date claimed |

"T" later document published after the international filing date or priority date and not in conflict with the application but cited to understand the principle or theory underlying the invention

"X" document of particular relevance; the claimed invention cannot be considered novel or cannot be considered to involve an inventive step when the document is taken alone

"Y" document of particular relevance; the claimed invention cannot be considered to involve an inventive step when the document is combined with one or more other such documents, such combination being obvious to a person skilled in the art

"&" document member of the same patent family

| Date of the actual completion of the international search | Date of mailing of the international search report |
|---|---|
| **04 August 2022** | **30 August 2022** |

| Name and mailing address of the ISA/CN | Authorized officer |
|---|---|
| **China National Intellectual Property Administration (ISA/CN)** **No. 6, Xitucheng Road, Jimenqiao, Haidian District, Beijing 100088, China** | |
| Facsimile No. **(86-10)62019451** | Telephone No. |

Form PCT/ISA/210 (second sheet) (January 2015)

INTERNATIONAL SEARCH REPORT
Information on patent family members

International application No.

**PCT/CN2022/094006**

| Patent document cited in search report | | | Publication date (day/month/year) | Patent family member(s) | | | Publication date (day/month/year) |
|---|---|---|---|---|---|---|---|
| CN | 113330754 | A | 31 August 2021 | KR | 20210114006 | A | 17 September 2021 |
| | | | | AU | 2021245167 | A1 | 04 November 2021 |
| | | | | CA | 3126285 | A1 | 16 July 2020 |
| | | | | US | 2021321207 | A1 | 14 October 2021 |
| | | | | EP | 3909261 | A1 | 17 November 2021 |
| | | | | WO | 2020142812 | A1 | 16 July 2020 |
| | | | | AU | 2020206801 | A1 | 04 February 2021 |
| | | | | IN | 202147036266 | A | 20 August 2021 |
| | | | | BR | 112021013704 | A2 | 21 September 2021 |
| | | | | US | 11234086 | B2 | 25 January 2022 |
| | | | | SG | 11202107460 | A1 | 30 August 2021 |
| | | | | AU | 2020206801 | B2 | 05 August 2021 |
| CN | 111050256 | A | 21 April 2020 | | None | | |
| US | 2017156002 | A1 | 01 June 2017 | US | 9661411 | B1 | 23 May 2017 |
| CN | 201216021 | Y | 01 April 2009 | | None | | |
| CN | 114079841 | A | 22 February 2022 | JP | 2022036000 | A | 04 March 2022 |
| | | | | US | 2022060814 | A1 | 24 February 2022 |
| | | | | KR | 20220022945 | A | 02 March 2022 |
| | | | | EP | 3958587 | A1 | 23 February 2022 |
| CN | 106034276 | A | 19 October 2016 | EP | 2986024 | A1 | 17 February 2016 |
| | | | | US | 2016050506 | A1 | 18 February 2016 |
| | | | | US | 2017006385 | A1 | 05 January 2017 |
| | | | | KR | 20160020287 | A | 23 February 2016 |
| | | | | US | 9479884 | B2 | 25 October 2016 |
| | | | | US | 10225662 | B2 | 05 March 2019 |
| | | | | KR | 102207928 | B1 | 26 January 2021 |
| | | | | EP | 2986024 | B1 | 01 May 2019 |
| | | | | CN | 106034276 | B | 27 September 2019 |

Form PCT/ISA/210 (patent family annex) (January 2015)